# EUROPEAN PATENT APPLICATION

(11) **EP 2 757 790 A1**
(43) Date of publication of application: **23.07.2014**
(21) Application number: 14152163.3
(22) Date of filing: 22.01.2014
(51) Int. Cl.: H04N 13/02

(54) **Photographing device and photographing method for taking picture by using a plurality of microlenses**

(30) Priority: 22.01.2013 KR 20130007173
(71) Applicant: Samsung Electronics Co., Ltd, Gyeonggi-do 443-742 (KR)
(72) Inventor: Lee, Tae-hee, Seoul (KR); Tuliakov, Stepan, Gyeonggi-do (KR); Han, Hee-chul, Gyeonggi-do (KR)
(74) Representative: Misselbrook, Paul

(57) **Abstract**

A photographing apparatus and method are provided. The photographing device includes: a main lens configured to transmit light beams reflected from a subject; a microlens array which includes a plurality of microlenses configured to filter and transmit the reflected light beams as different colors; an image sensor configured to sense the light beams that are transmitted by the plurality of microlenses; a data processor configured to collect pixels of positions corresponding to one another from a plurality of original images sensed by the image sensor to generate a plurality of sub images; a storage device configured to store the plurality of sub images; and a controller configured to detect pixels matching one another in the plurality of sub images stored in the storage device and to acquire color information and depth information of an image of the subject. Therefore, color information and depth information are restored without reducing resolution.

## Description

### BACKGROUND

### 1. Field

Apparatuses and methods consistent with exemplary embodiments relate to providing a photographing device and a photographing method, and more particularly, to providing a photographing device and a photographing method for taking a picture by using a plurality of microlenses.

### 2. Description of the Related Art

Various types of electronic devices have been developed and supplied with the development of electronic technologies. In particular, services which provide exchanges with other people, like social network services (SNSs), have gained popularity. Accordingly, photographing devices that generate a content by taking a picture of surroundings have been increasingly used.

Examples of the photographing devices include various types of devices such as digital cameras, portable phones, tablet personal computers (PCs), laptop PCs, personal digital assistants (PDAs), etc. A user uses a photographing device to take and use various pictures.

In the related art, photographing devices perform photographing by using a method of focusing on subjects and storing subject images by using charge-coupled device (CCDs) or complementary metal oxide semiconductor (CMOS) image sensors. Photographing devices may support auto focusing functions to automatically focus on subjects. However, if photographing is performed when focusing is not appropriately performed, or when several subjects exist, photographing may be performed when a subject desired by a user is not in focus.

In this case, the user has difficulty re-performing photographing. In order to address this difficulty, light field cameras have been developed to perform photographing by using a plurality of microlenses and then performing focusing.

In the related art, light field cameras perform demosaic jobs with respect to images generated by light filtered by filters to interpolate colors. Therefore, blur phenomena occurs around boundaries of objects of interpolated images. Accordingly, resolution of the interpolated images is reduced.

### SUMMARY

Exemplary embodiments address at least the above problems and/or disadvantages and other disadvantages not described above. Also, the exemplary embodiments are not required to overcome the disadvantages described above, and an exemplary embodiment may not overcome any of the problems described above.

One or more exemplary embodiments provide a photographing device and a photographing method for taking a picture by using a plurality of microlenses performing color-filtering to prevent a reduction in a resolution.

According to an aspect of an exemplary embodiment, there is provided a photographing device comprising: a main lens configured to transmit light beams reflected from a subject; a microlens array which comprises a plurality of microlenses configured to filter and transmit the reflected light beams as different colors; an image sensor configured to sense the light beams that are transmitted by the plurality of microlenses to sense a plurality of original images; a data processor configured to collect pixels of positions corresponding to one another from the plurality of original images sensed by the image sensor to generate a plurality of sub images; a storage device configured to store the plurality of sub images; and a controller configured to detect pixels matching one another in the plurality of sub images stored in the storage device, and acquire color information and depth information of an image of the subject based on a result of the detection.

The controller may performs at least one of a three-dimensional (3D) object detecting job and a re-focusing job by using the plurality of sub images.

The microlens array may be divided into a plurality of microlens groups that are repeatedly arrayed. A plurality of microlenses may be arrayed in each of the plurality of microlens groups according to preset color patterns, wherein colors separately selected from red (R), blue (B), green (G), cyan (C), yellow (Y), white (W), and emerald (E) are respectively allocated to the plurality of microlenses.

The image sensor may be divided into a plurality of pixel groups which correspond to the plurality of microlenses. Each of the plurality of pixel groups may comprise a plurality of pixels, and the total number of pixels of the image sensor exceeds the number of the microlenses.

Color coating layers may be formed on surfaces of the plurality of microlenses, and colors of the color coating layers may be repeated as preset patterns.

The microlens array may comprise: a first substrate on which the plurality of microlenses are arrayed in a matrix pattern; and a second substrate on which a plurality of color filters respectively corresponding to the plurality of microlenses are arrayed. Colors of the plurality of color filters may be repeated as preset patterns.

According to an aspect of another exemplary embodiment, there is provided a photographing method including: filtering and transmitting light beams incident through a main lens by using a microlens array comprising a plurality of microlenses; sensing the light beams that are transmitted by the plurality of microlenses, using an image sensor to acquire a plurality of original images; collecting pixels of positions corresponding to one another from the plurality of original images to generate a plurality of sub images;storing the plurality of sub images; and detecting pixels matching one another in the plurality of sub images to restore color information and depth information of a subject image.

The photographing method may further comprise: performing at least one of a three-dimensional (3D) object detecting job and a re-focusing job by using the color information and the depth information.

The microlens array may be divided into a plurality of microlens groups that are repeatedly arrayed. A plurality of microlenses may be arrayed in each of the plurality of microlens groups according to preset color patterns, wherein colors separately selected from least red (R), blue (B), green (G), cyan (C), yellow (Y), white (W), and emerald (E) are respectively allocated to the plurality of microlenses.

Color coating layers may be formed on surfaces of the plurality of microlenses, and colors of the color coating layers may be repeated as preset patterns.

### BRIEF DESCRIPTION OF THE DRAWINGS

The above and/or other aspects will be more apparent by describing certain exemplary embodiments with reference to the accompanying drawings, in which:
FIG. 1 is a view illustrating a structure of a photographing device according to an exemplary embodiment;
FIGS. 2 and 3 are views illustrating a process of allowing light that has penetrated through a main lens to be incident onto a microlens array;
FIG. 4 is a view illustrating a principle of acquiring a multi-view image by using a plurality of microlenses;
FIG. 5 is a view illustrating a microlens array according to an exemplary embodiment;
FIG. 6 is a view illustrating a section of a microlens array and an image sensor according to an exemplary embodiment;
FIG. 7 is a view illustrating a plurality of original images sensed by using a plurality of microlenses;
FIGS. 8A and 8B are views illustrating a plurality of sub images generated by collecting pixels from positions corresponding to one another in the original images of FIG. 7;
FIGS. 9 and 10 are views illustrating various sections of a microlens array;
FIGS. 11A through 15 are views illustrating color patterns of a microlens array according to various exemplary embodiments;
FIG. 16 is a flowchart illustrating a photographing method according to an exemplary embodiment;
FIG. 17 is a flowchart illustrating an image processing method using a plurality sub images according to an exemplary embodiment; and
FIG. 18 is a view illustrating a refocusing method of image processing according to an exemplary embodiment.

### DETAILED DESCRIPTION OF THE EXEMPLARY EMBODIMENTS

Certain exemplary embodiments are described in greater detail with reference to the accompanying drawings.

In the following description, like drawing reference numerals are used for the same elements, even in different drawings. The matters defined in the description, such as detailed construction and elements, are provided to assist in a comprehensive understanding of the exemplary embodiments. However, exemplary embodiments can be practiced without those specifically defined matters. Also, well-known functions or constructions are not described in detail since they would obscure the exemplary embodiments with unnecessary detail.

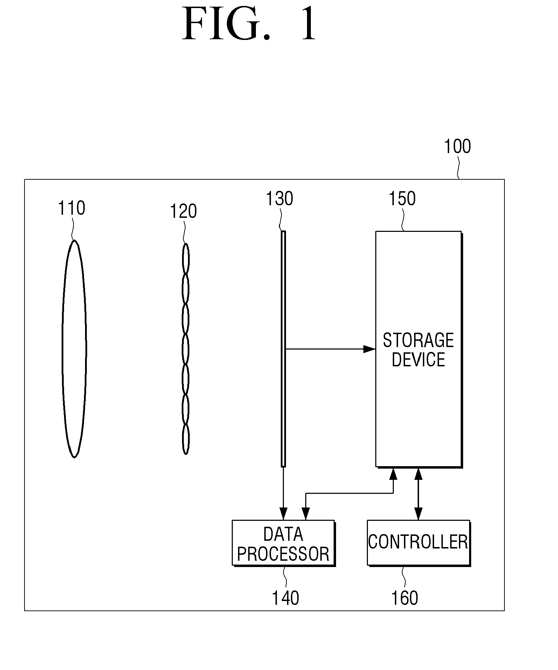

FIG. 1 is a view illustrating a structure of a photographing device 100 according to an exemplary embodiment. Referring to FIG. 1, the photographing device 100 includes a main lens 110, a microlens array 120, an image sensor 130, a data processor 140, a storage device 150, and a controller 160. The photographing device 100 of FIG. 1 has simplified elements for descriptive convenience, but may further include various types of additional elements. For example, the photographing device 100 may further include various types of additional elements such as a flash, a reflector, an iris, a housing, etc. The main lens 110 may be omitted or other lenses additionally included in the photographing device 100.

The photographing device 100 of FIG. 1 may be realized as a plenoptic camera or a light field camera which capture a multi-view image by using a plurality of microlenses.

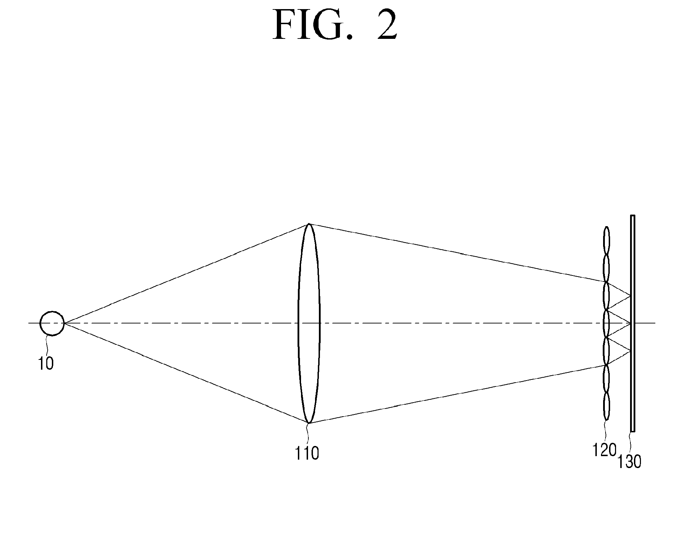

The main lens 110 transmits light beams reflected from a subject. The main lens 110 may be realized as a general-purpose lens, a wide-angle lens, or the like. The main lens 110 is not limited to a single lens, as shown in FIG. 2, but may include a group of a plurality of lens.

The microlens array 120 includes a plurality of microlenses. Colors are respectively allocated to the microlenses so that the microlenses filter and transmit the reflected light beams, incident from the main lens 110, as different colors. Specifically, the microlenses transmit light beams of various colors such as red (R), blue (B), green (G), cyan (C), magenta (M), yellow (Y), white (W), emerald (E), etc. For color filtering, color material layers may be respectively coated on surfaces of the microlenses or a substrate. The substrate, on which filters of different colors are formed as patterns corresponding to positions of the microlenses, may be disposed on the microlenses.

The plurality of microlenses may be disposed according to preset color patterns. The preset color patterns and the disposition method according to the preset color patterns will be described in detail later.

The light beams penetrating through the microlens array 120 are incident onto the image sensor 130 which is disposed behind the microlens array 120. The image sensor 130 senses the light beams that have penetrated through the plurality of microlenses. The image sensor 130 may be realized as an image sensor array in which a plurality of complementary metal oxide semiconductor (CMOS) or charge-coupled device (CCD) image sensors are arrayed. Therefore, the image sensor 130 generates a plurality of original images according to the light beams that have penetrated through the microlenses.

The data processor 140 generates a plurality of sub images by using the plurality of original images sensed by the image sensor 130. The sub images refer to images that are generated by combining pixels captured in various views. In other words, the plurality of sub images may include images that are generated by capturing a subject in different views.

The data processor 140 collects pixels of corresponding positions from the plurality of original images to generate the plurality of sub images. A method of generating the sub images will be described in detail later.

The storage device 150 stores the plurality of sub images generated by the data processor 140.

The controller 160 performs various operations by using the plurality of sub images stored in the storage device 150. For example, the controller 160 detects pixels matching one another in the plurality of sub images to perform disparity matching. The disparity matching refers to an operation of calculating a distance from a subject, i.e., depth information, by using position differences between pixels indicating the same subject when the pixels exist in different positions according to the plurality of sub images.

As described above, since the plurality of microlenses perform color-filtering, pixels of the sub images have different types of color information. Therefore, the controller 160 combines color values of the pixels matching one another to restore color information of the subject.

The controller 160 performs various image processing jobs by using the restored color information, the depth information, etc. For example, the controller 160 performs a re-focusing job for re-adjusting a focus based on a point desired by a user so as to generate an image. The controller 160 performs a three-dimensional (3D) object detecting job for detecting (3D) object.

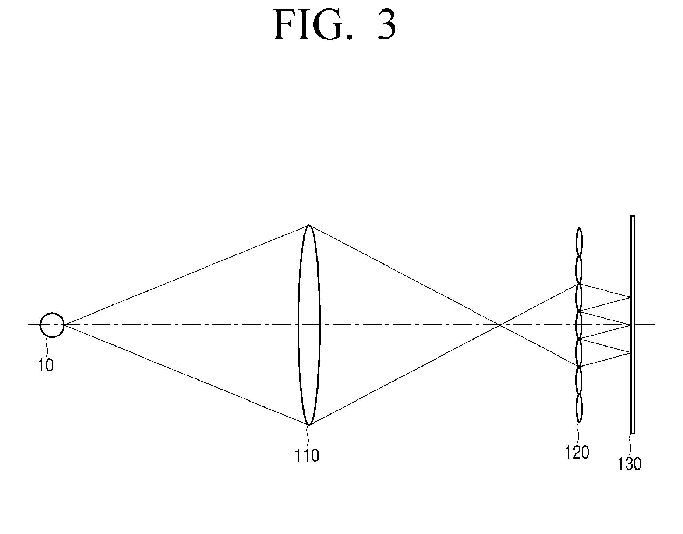

FIGS. 2 and 3 are views illustrating a process of allowing light that has penetrated through the main lens 110 to be incident onto the microlens array 120. As shown in FIG. 2, light reflected from a subject 10 penetrates through the main lens 110 and converges in an optical direction. When the microlens array 120 is positioned within the converging point (i.e., a second main point), the reflected light is normally incident onto the microlens array 120.

When the microlens array 120 is positioned outside the converging point, the reflected light is incident onto lens array 120 as a reverse image.

The microlenses convert the incident light into color light and transmit the color light. The transmitted light is incident onto the image sensor 130.

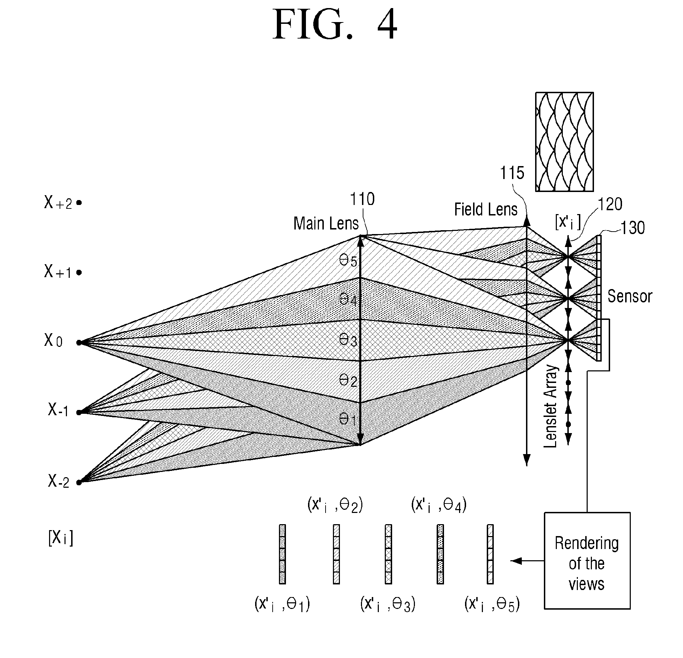

FIG. 4 is a view illustrating a principle of acquiring a multi-view image by using a plurality of microlenses. As shown in FIG. 4, light beams reflected from points X₋₂, X₁, and X₀ are refracted through the main lens 110 and then incident onto the microlens array 120. As shown in FIG. 4, a field lens 115 is used to adjust refraction angles. A surface of the field lens 115 facing the microlens array 120 may be flat, and an opposite surface of the field lens 115, i.e., a surface facing the main lens 110, may be convex. The field lens 115 transmits light beams, which have penetrated through the main lens 110, to the microlens array 120. As shown in FIG. 4, light beams that have respectively penetrated through areas θ1 through θ5 of the main lens 110, form images of different viewpoints. Therefore, images of five viewpoints are acquired in the areas θ1 through θ5.

Colors may be allocated to the microlenses of the microlens array 120 according to preset color patterns. The color patterns may be variously realized.

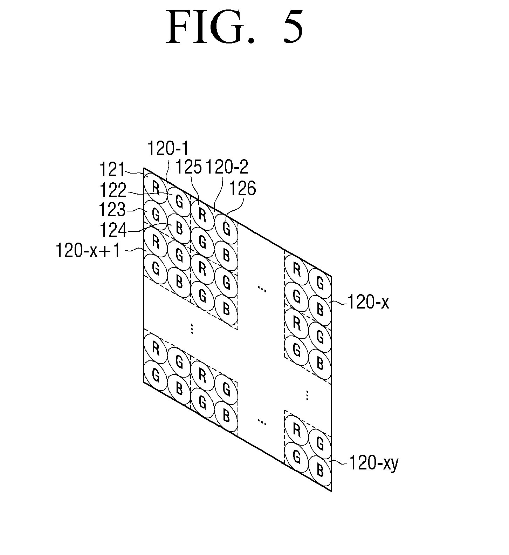

FIG. 5 is a view illustrating color patterns of a microlens array according to an exemplary embodiment

Referring to FIG. 5, the microlens 120 is divided into a plurality of microlens groups 120-1, 120-2, ..., and 120-xy. A plurality of microlenses, to which separately selected colors are respectively allocated, are disposed in each of the plurality of microlens groups 120-1, 120-2, ..., and 120-xy according to preset color patterns. In FIG. 5, a microlens 121, to which a R color is allocated, and a microlens 122, to which a G color is allocated, are disposed on a first line of a microlens group. A microlens 123, to which a G color is allocated, and a microlens 124, to which a B color is allocated, are disposed on a second line of the microlens group. This microlens group is repeatedly disposed on the microlens 120. In FIG. 5, a plurality of microlens groups are arrayed on y lines and x columns of the microlens 120.

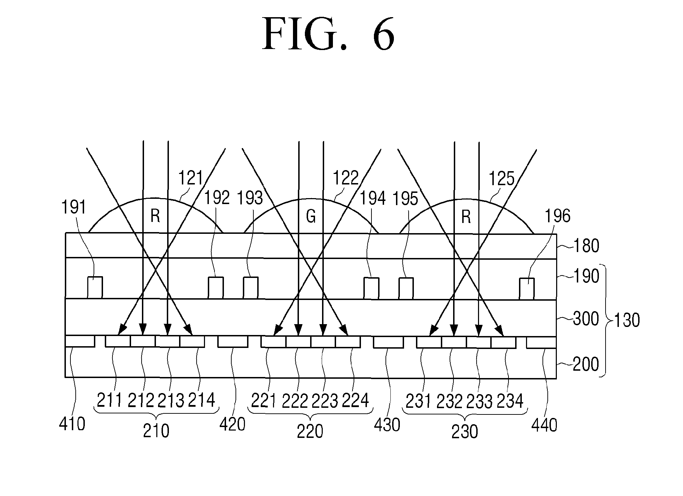

FIG. 6 is a view illustrating a section of the microlens array 120 and a section of the image sensor 130 according to an exemplary embodiment.

In particular, FIG. 6 illustrates a cross-section taken along a first line of the microlens array 120 illustrated in FIG. 5.

Referring to FIG. 6, the microlens array 120 includes a substrate 180 on which a plurality of microlenses 121, 122, 125, and the image sensor 130 are disposed. The image sensor 130 is disposed in contact with the microlens array 120 The substrate 180 may be formed of a transparent material.

The image sensor 130 includes a first insulating layer 190, a second insulating layer 300, and a support substrate 200. Metal lines 191 through 196 for electrical connections are disposed in the first insulating layer 190. The metal lines 191 through 196 may be designed not to block paths of light beams that have penetrated through the microlenses. As shown in FIG. 6, the metal lines 191 through 196 are disposed in one insulating layer 190. However, the metal lines 191 through 196 may be dispersedly disposed in a plurality of the insulating layers.

A plurality of pixel groups 210, 220, 230, are disposed in the support substrate 200. Image sensors 211 through 214, 221 through 224, and 231 through 234 form a plurality of pixels and are respectively disposed in the pixel groups 210, 220, 230. The image sensors 211 through 214, 221 through 224, and 231 through 234 respectively sense light beams that have penetrated through the microlenses 121, 122, and 123. Isolation layers 410, 420, 430, and 440 are formed between the pixel groups to prevent interferences between the image sensors 211 through 214, 221 through 224, and 231 through 234.

The metal lines 191 through 196 connect the image sensors 211 through 214, 221 through 224, and 231 through 234 to external electrode pads. Therefore, the metal lines 191 through 196 may transmit electrical signals respectively output from the image sensors 211 through 214, 221 through 224, and 231 through 234 to the data processor 140 and the storage device 150.

As shown in FIG. 6, the total number of image sensors in a pixel group exceeds the number of microlenses. Specifically, 4*4 image sensors are disposed in a position corresponding to one microlens.

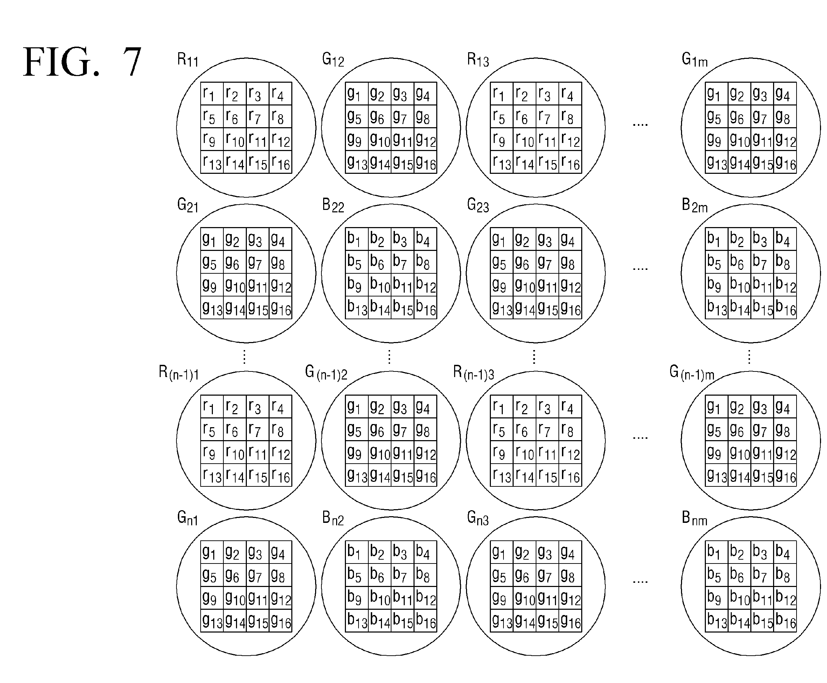

FIG. 7 is a view illustrating a plurality of original images sensed by using the microlens array 120 including R, G, and B color patterns. Microlenses of various colors are disposed in the microlens array 120.

Referring to FIG. 7, light beams that have penetrated through the microlenses 121, 122, 123, 124, 125, form images of 4*4 pixels. For descriptive convenience, the images respectively generated by the microlenses 121, 122, 123, 124, 125, are referred to as original images. The microlenses 121, 122, 123, 124, 125, are respectively expressed with English capital letters "R," "G," and "B" according to colors and are divided into nm lines and columns (wherein n denotes a line number, and m denotes a column number) according to their respective positions. Pixels constituting one image are respectively expressed with small letters "r," "g," and "b." Numbers 1 through 16 are added according to positions of the pixels to divide the pixels. The number of original images corresponds to the number of microlenses. In the example illustrated in FIG. 7, n*m original images are acquired.

The data processor 140 combines pixels in positions corresponding to one another among pixels constituting sensed images to generate a plurality of sub images.

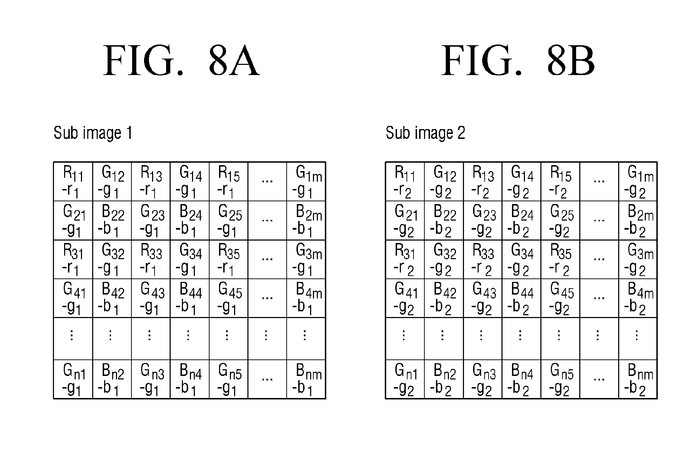

FIGS. 8A and 8B are views illustrating a method of generating a plurality of sub images. Referring to FIG. 8A, a sub image 1 includes n*m pixels. The sub image 1 is formed of a combination of pixels r1, g1, and b1 positioned in first lines and first columns of a plurality of original images.

Referring to FIG. 8B, a sub image 2 is formed of a combination of pixels r2, g2, and b2 positioned in first lines and second columns of a plurality of original images. As described above, a total of 16 sub images may be generated by the data processor 140 and stored in the storage device 150.

The microlenses of the microlens array 120 may further include color coating layers or color filters to perform color-filtering.

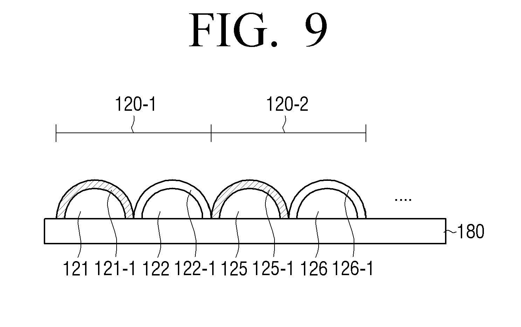

FIG. 9 is a view illustrating a structure of the microlens array 120 according to an exemplary embodiment. Specifically, FIG. 9 illustrates a section of a first line of the microlens array 120 illustrated in FIG. 5.

The microlens array 120 includes microlenses 121, 122, 125, and 126 and the substrate 180 which supports the microlenses 121, 122, 125, and126. Color coating layers 121-1, 122-1, 125-1, and 126-1 are respectively formed on surfaces of the microlenses 121, 122, 125, and 126. The color coating layers 121-1, 122-1, 125-1, and 126-1 may be formed of dyes having colors. Colors of the color coating layers 121-1, 122-1, 125-1, and 126-1 may be repeated in preset patterns. For instance, R and G colors are repeated in an odd line, and G and B colors are repeated in an even line.

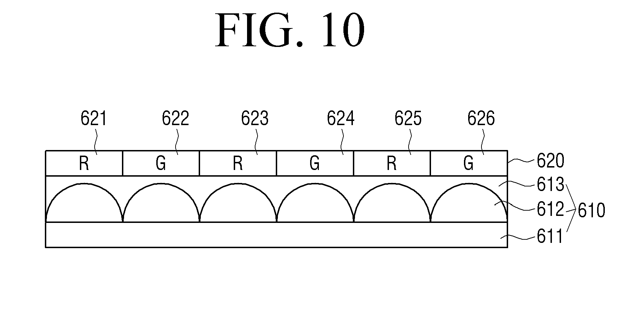

FIG. 10 is a view illustrating a structure of the microlens array 120 according to another exemplary embodiment. Referring to FIG. 10, the microlens array 120 includes a first substrate layer 610 and a second substrate layer 620. The first substrate layer 610 includes a plurality of microlenses 612 and a substrate 611 on which the microlenses 612 are arrayed. An empty space 613 may be formed between the microlenses 612 and the first substrate 610 or a transparent material may be disposed in the empty space 613 to fill between the microlenses 612 and the first substrate 610.

The second substrate 620 includes a plurality of color filters 621 through 626. The color filters 621 through 626 are arrayed to correspond to positions of the plurality of microlenses 612. The color filters 621 through 626 perform color-filtering for transmitting light beams of predetermined colors. Colors of the plurality of color filters 621 through 626 may be repeated in preset patterns. For example, if the colors of the plurality of color filters 621 through 626 have color patterns as shown in FIG. 5, a first line of the microlens array 120 may be realized with color patterns in which R and G colors are repeated.

As described above, microlenses may be realized as various types of structures to perform color-filtering. Colors of the microlenses may be realized as various patterns. Examples of color patterns according to various exemplary embodiments will now be described in detail.

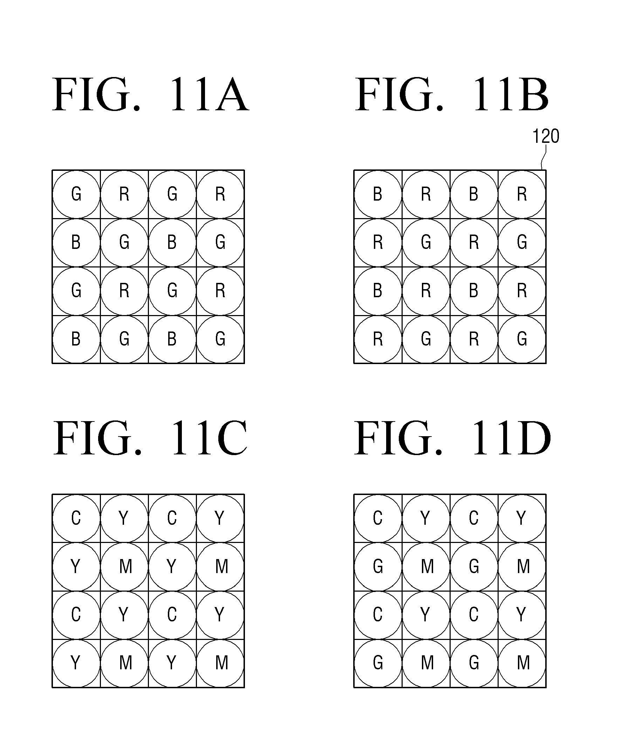

FIGS. 11A through 11D are views illustrating color patterns repeated in a unit of four microlenses. In FIG. 11A, G and R color microlenses are repeated in odd lines, and B and G color microlenses are repeated in even lines. Specifically, in FIG. 11A, a microlens group in which four color microlenses respectively having G, R, B, and G colors are arrayed in a 2*2 matrix which is repeatedly arrayed.

In FIG. 11 B, B, R, R, and G color microlens groups are repeatedly arrayed. In FIG. 11C, C, Y, Y, and M color microlens groups are repeatedly arrayed. In FIG. 11D, C, Y, G, and M color microlens groups are repeatedly arrayed.

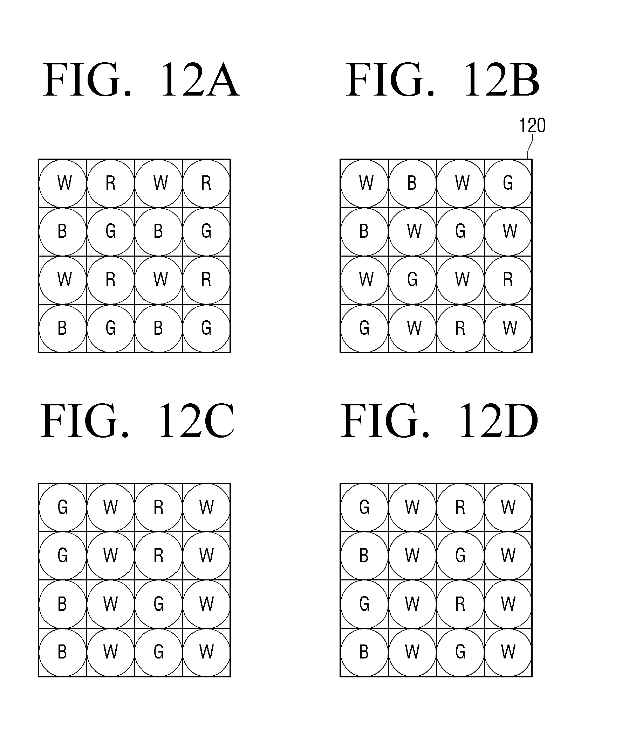

FIGS. 12A through 12D are views illustrating color patterns including white (W) color microlenses according to an exemplary embodiment.

In FIG. 12A, W and R color microlenses are repeatedly arrayed in odd lines, and B and G color microlenses are repeatedly arrayed in even lines. A W color lens refers to a lens that transmits W light. For example, the W color lens may a lens which is formed of only a transparent material without an additional color coating layer or color filter layer.

In FIG. 12B, W, B, W, and G color microlenses are repeatedly arrayed in odd lines, and B, W, G, and W color microlenses are repeatedly arrayed in even lines. In the above described exemplary embodiment, colors are repeated in the unit of two microlenses in each line. However, as shown in FIG. 12B, the cycle for which colors are repeated may be 2 or more.

In FIG. 12C, W color microlenses are arrayed in all even columns, and microlenses are arrayed as patterns in which G, G, B, and B and R, R, G, and G are alternatively repeated, in odd columns.

In FIG. 12D, W color microlenses are arrayed in even columns, and microlenses are arrayed as patterns in which G, B, G, and B and R, G, R, and G are alternatively repeated, in odd columns.

In FIGS. 11A through 12D, microlens arrays may be divided into groups each including 2*2 microlenses. However, the number of microlenses in each group may be variously realized.

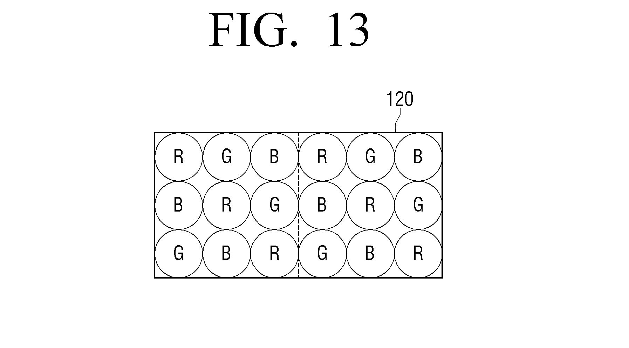

FIG. 13 is a view illustrating a structure of the microlens array 120 including a plurality of microlens groups each including 3*3 microlenses.

Referring to FIG. 13, R, G, and B color microlenses are arrayed on a first line of one microlens group, B, R, and G color microlenses are arrayed on a second line of the one microlens group, and G, B, and R color microlenses are arrayed on a third line of the one microlens group. The microlens array 120 may be realized as a group which includes 3*3 microlenses and is repeatedly arrayed.

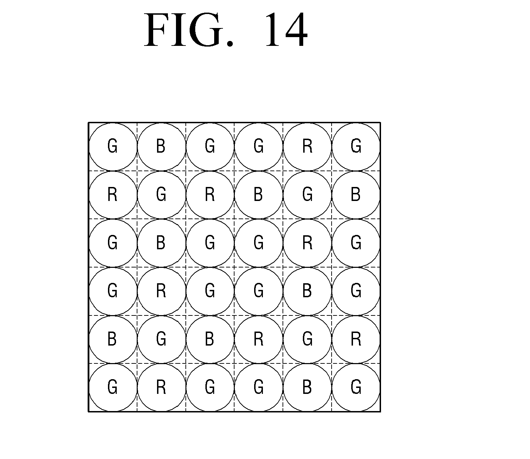

FIG. 14 is a view illustrating a structure of the microlens array 120 including a plurality of microlens groups each including 6*6 microlenses.

Referring to FIG. 14, G, B, G, G, R, and G color microlenses are arrayed on a first line of one microlens group, R, G, R, B, G, and B color microlenses are arrayed on a second line of the one microlens group, G, B, G, G, R, and G color microlenses are arrayed on a third line of the one microlens group, G, R, G, G, B, and G are arrayed on a fourth line of the one microlens group, B, G, B, R, G, and R are arrayed on a fifth line of the one microlens group, and G, R, G, G, B, and G color microlenses are arrayed on a sixth line of the one microlens group. A microlens group having these color patterns may be repeatedly arrayed.

In the above-described exemplary embodiments, each microlens is arrayed in a matrix, but an array form is not limited to a matrix form.

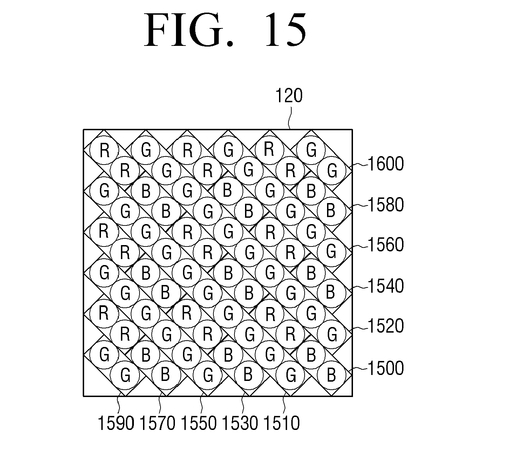

FIG. 15 is a view illustrating a plurality of microlenses arrayed in an diagonal direction according to an exemplary embodiment. Referring to FIG. 15, the microlens array 120 includes a plurality of diagonal columns 1500, 1510, 1520, 1530, 1540, 1550, 1560, 1570, 1580, 1590, and 1600. Two R color microlenses and two B color microlenses are alternately arrayed on the central diagonal column 1500. Columns including a plurality of G color microlenses are arrayed on either side of the central diagonal column 1500. As shown in FIG. 15, columns including mixtures of R and B colors and columns including only G colors may be alternately arrayed in the diagonal direction.

As described above, light beams that have penetrated through the microlens array 120 having various colors are incident onto the image sensor 130. Therefore, a plurality of original images are acquired. The data processor 140 collects pixels positioned at points corresponding to one another from pixels of original images, as described with reference to FIG. 8, to generate a plurality of sub images.

The microlens array 120 filters color light beams by using a plurality of microlenses. Since color information is divided, acquired, and restored according to sub images, color information of an image may be restored without performing color interpolation based on a pixel value (e.g., like a demosaic technique). Therefore, a reduction in a resolution caused by blurring occurring in a color interpolation process may be prevented.

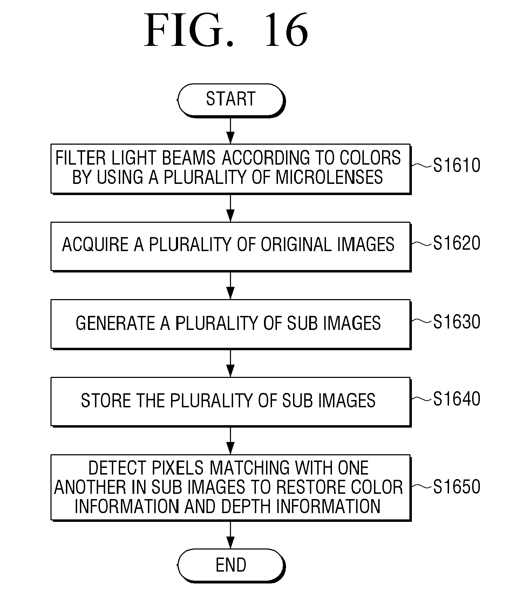

FIG. 16 is a flowchart illustrating a photographing method according to an exemplary embodiment. Referring to FIG. 16, if a photographing command is input, a photographing device opens a shutter. If light beams are incident through a main lens, the photographing device transmits the incident light beams by using a plurality of microlenses and filters the transmitted light beams according to colors, in operation S1610. The microlenses may be realized as various types of structures as shown in FIGS. 9 and 10 to filter colors respectively matching the microlenses. As described above, color patterns of a microlens array may be variously realized.

The light beans that have respectively penetrated through the microlenses are incident onto an image sensor. In operation S1620, the image sensor acquires a plurality of original images based on the light beams that have penetrated through the plurality of microlenses. The original images are acquired by capturing a subject at different viewpoints and include colors respectively corresponding to the microlenses.

In operation S1630, the photographing device combines pixels of the plurality of original images to generate a plurality of sub images.

In operation S1640, the photographing device stores the generated sub images.

In operation S1650, the photographing device detects pixels matching one another from the sub images to restore color information and depth information. The color information and the depth information may be used for a re-focusing job, a 3D object detecting job, etc.

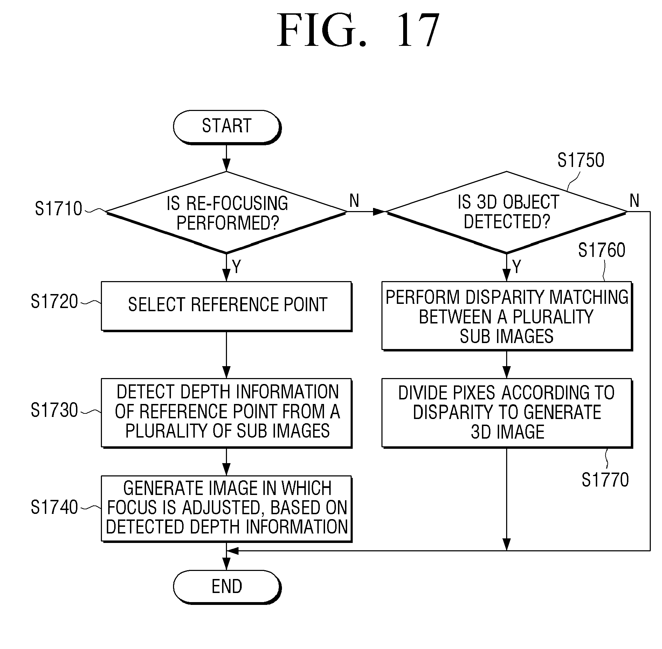

FIG. 17 is a flowchart illustrating a method of performing various types of image processing according to user selections according to an exemplary embodiment. Referring to FIG. 17, a user selects from a menu which includes capturing a subject and performing image processing with respect to the captured subject. The menu may further include a re-focusing menu, a 3D object detecting menu, a viewpoint changing menu, etc.

If a re-focusing command is input by the selection of the menu in operation S1710, a photographing device selects and displays one of a plurality of sub images. For example, the photographing device may display a sub image including pixels in a middle position.

In operation S1720, the user selects a reference point of the displayed sub image on which the user wants to focus.

If the reference point is selected, the controller 160 checks depth information of the reference point in operation S1730. The depth information may be detected by using position differences between pixels having pixel values corresponding to one another from pixels of the plurality of sub images. The controller 160 shifts the pixels of the sub images according to the checked depth information. In operation S1740, pixel values of the shifted pixels are adjusted as their average value to generate an image which is focused at the selected reference point. As a result, objects having depth information corresponding to the selected reference point are clearly displayed

If a 3D object detecting command is input in operation S1750, pixels corresponding to one another between the plurality of sub images perform a disparity matching job for extracting disparities of the pixels in operation S1760.

In operation S1770, left and right eye images are generated according to the disparities of the pixels. Specifically, in an object having a deep depth, a pixel distance between a pixel position in the left eye image and a pixel position in the right eye image is large. Conversely, in an object having a shallow depth, a pixel distance between a pixel position in the left eye image and a pixel position in the right eye image is small. Therefore, a 3D image may be generated.

As described with reference to FIGS. 16 and 17, according to various exemplary embodiments, after a photographing device captures a subject, the photographing device adjusts the subject by using various methods according to user selections. Therefore, a color image may be generated without performing demosaic processing.

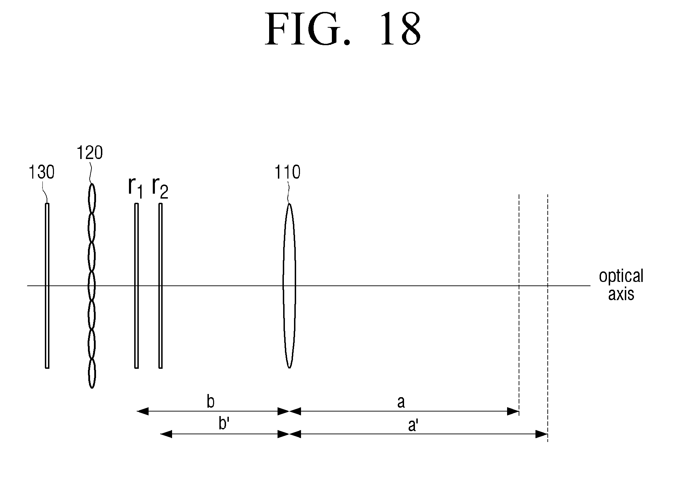

FIG. 18 is a view illustrating a re-focusing job which is an example of image processing. Light incident onto a photographing device may be expressed as r(q, p). That is, a radiance of light having a position q and an angle p. The light penetrates through a lens and then is incident onto an image sensor through a space formed between the lens and the image sensor. Therefore, a conversion matrix of a radiance of an image acquired by the image sensor is expressed as a multiplication of a characteristic matrix and a characteristic matrix of the space.

Re-focusing refers to a job for acquiring a focused image and forming a re-focused image. In other words, the re-focusing may be performed according to a method of calculating radiance information reaching a flat surface of the image sensor in another position by using pre-acquired radiance information.

FIG. 18 is a view illustrating an example of the re-focusing job. FIG. 18 illustrates a focus that is adjusted from r1 to r2.

Referring to FIG. 18, if an image of a subject at a point a distance a from the main lens 110 is formed on a surface r1, that is a point a distance b from the main lens 110 toward the microlens array 120, an image of the subject at a point a distance a' from the main lens 110 is formed on a surface r2, that is a point a distance b' from the main lens 110 toward the microlens array 120.

The controller 160 may acquire radiance information of light focused on the surface r2 by using radiance information of light focused on the surface r1. For example, changed radiance information may be acquired by using the equation: r'(q, p)=r(q-tp, p), wherein t denotes a distance passing between the main lens 110 and the image sensor 130. If the changed radiance information is acquired, the controller 160 may form an image in which re-focusing has been performed, based on the changed radiance information. The controller 160 may check depth information of pixels of a plurality of sub images to combine the pixels according to the changed radiance information in order to acquire an image in which a focus has been changed. The re-focusing method described with reference to FIG. 18 is only an example, and thus re-focusing or other types of image processing may be performed according to various methods.

According to various exemplary embodiments color information is restored by using a plurality of sub images acquired by using a plurality of microlenses. Therefore, various images may be generated without lowering resolutions.

A photographing method according to the above-described exemplary embodiments may be applied to a photographing apparatus including a plurality of microlenses including color filters. Specifically, the photographing method may be coded as a program code for performing the photographing method and stored on a non-transitory computer-readable medium. The non-transitory computer-readable medium may be installed in a photographing device, as described above, to support the photographing device so as to perform the above-described method therein.

The non-transitory computer-readable medium refers to a medium which does not store data for a short time, such as a register, a cache memory, a memory, or the like, but semi-permanently stores data and is readable by a device. Specifically, the above-described applications or programs may be stored and provided on a non-transitory computer readable medium such as a CD, a DVD, a hard disk, a blue-ray disk, a universal serial bus (USB), a memory card, a ROM, or the like.

The foregoing exemplary embodiments and advantages are merely exemplary and are not to be construed as limiting. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A photographing device (100) comprising:
a main lens (110) which transmits light beams reflected from a subject (10);
a microlens array (120) which comprises a plurality of microlenses (121, 122) which filter and transmit the reflected light beams as different colors;
an image sensor (130) which senses the light beams that have respectively penetrated the plurality of microlenses;
a data processor (140) which collects pixels of positions corresponding to one another from a plurality of original images sensed by the image sensor (130) to generate a plurality of sub images;
a storage device (150) which stores the plurality of sub images; and
a controller (160) which detects pixels matching with one another in the plurality of sub images stored in the storage device to acquire color information and depth information of an image of the subject.

2. The photographing device (100) of claim 1, wherein the controller (160) performs a three-dimensional (3D) object detecting job or a re-focusing job by using the plurality of sub images.

3. The photographing device (100) of claim 1, wherein the microlens array (120) is divided into a plurality of microlens groups that are repeatedly arrayed,
wherein a plurality of microlenses (121, 122) are arrayed in each of the plurality of microlens groups according to preset color patterns, and
wherein colors separately selected from at least red (R), blue (B), green (G), cyan (C), yellow (Y), white (W), and emerald (E) are respectively allocated to the plurality of microlenses.

4. The photographing device (100) of claim 1, wherein the image sensor (130) is divided into a plurality of pixel groups which respectively correspond to the plurality of microlenses, and
wherein each of the plurality of pixel groups comprises a plurality of pixels, and the total number of pixels of the image sensor (130) exceeds the number of the microlenses.

5. The photographing device (100) of claim 4, wherein color coating layers are formed on surfaces of the plurality of microlenses, and
wherein colors of the color coating layers are repeated as preset patterns.

6. The photographing device (100) of claim 4, wherein the microlens array (120) comprises:
a first substrate on which the plurality of microlenses are arrayed in a matrix pattern; and
a second substrate on which a plurality of color filters respectively corresponding to the plurality of microlenses are arrayed,
wherein colors of the plurality of color filters are repeated as preset patterns.

7. A photographing method comprising:
filtering and transmitting light beams incident through a main lens (110) by using a microlens array (120) comprising a plurality of microlenses (121, 122);
sensing the light beams that have penetrated through the plurality of microlenses, by using an image sensor (130) to acquire a plurality of original images;
collecting pixels of positions corresponding to one another from the plurality of original images to generate a plurality of sub images;
storing the plurality of sub images; and
detecting pixels matching with one another in the plurality of sub images to restore color information and depth information of a subject image.

8. The photographing method of claim 7, further comprising:
performing a three-dimensional (3D) object detecting job or a re-focusing job by using the color information and the depth information.

9. The photographing method of claim 7, wherein the microlens array (120) is divided into a plurality of microlens groups that are repeatedly arrayed,
wherein a plurality of microlenses are arrayed in each of the plurality of microlens groups according to preset color patterns, wherein colors separately selected from at least red (R), blue (B), green (G), cyan (C), yellow (Y), white (W), and emerald (E) are respectively allocated to the plurality of microlenses.

10. The photographing method of claim 7, wherein color coating layers are formed on surfaces of the plurality of microlenses, and
wherein colors of the color coating layers are repeated as preset patterns.
